# EUROPÄISCHE PATENTANMELDUNG

(11) **EP 2 059 104 A2**
(43) Veröffentlichungstag der Anmeldung: **13.05.2009**
(21) Anmeldenummer: 08167863.3
(22) Anmeldetag: 29.10.2008
(51) Int. Cl.: H05K 7/20

(54) **Kühlvorrichtung für ein Computersystem**

(30) Priorität: 06.11.2007 DE 102007053219
(71) Anmelder: Fujitsu Siemens Computers GmbH, 80807 München (DE)
(72) Erfinder: König, Christoph, 85521, Ottobrunn (DE)
(74) Vertreter: Epping - Hermann - Fischer

(57) **Zusammenfassung**

Die Erfindung betrifft eine Kühlvorrichtung für ein Computersystem und ein Verfahren zum Kühlen mindestens einer Wärme erzeugenden Komponente eines Computersystems.
Die Kühlvorrichtung für das Computersystem weist einen Verdampfer (2) für ein Arbeitsmittel auf, der thermisch an die mindestens eine Wärme erzeugende Komponente des Computersystems koppelbar ist. Dabei ist die Kühlvorrichtung als Wärmekraftmaschine oder als Absorptionskältemaschine zur Durchführung eines thermodynamischen Kreisprozesses eingerichtet.

## Beschreibung

Die Erfindung betrifft eine Kühlvorrichtung für ein Computersystem und ein Verfahren zum Kühlen mindestens einer Wärme erzeugenden Komponente eines Computersystems.

Heutige Computersysteme, zum Beispiel die so genannten Serverfarmen, können bereits bis zu einigen tausend Prozessoren aufweisen. Angesichts der zunehmenden Nachfrage an Netzwerkdiensten ist absehbar, dass die Anzahl der Prozessoren in zukünftigen Systemen noch weiter steigen wird. Darüber hinaus steigt mit zunehmender Leistungsfähigkeit der einzelnen Prozessoren auch deren Bedarf an elektrischer Leistung. Dieses resultiert zusammengenommen zum einen in einem enormen Primärenergiebedarf (Energieverbrauch) großer Computersysteme und zum anderen in einer großen anfallenden Wärmemenge, die durch geeignete Kühlvorrichtungen aus dem Computersystem transportiert werden muss, wobei bekannt ist, die anfallende Wärme zu Heizungszwecken oder zur Warmwasserbereitung einzusetzen und so nutzbar zu machen.

Es ist eine Aufgabe der Erfindung, eine Kühlvorrichtung für ein Computersystem und ein Verfahren zum Kühlen mindestens einer Wärme erzeugenden Komponente eines Computersystems zu schaffen, mit denen eine effektive Kühlung und eine effiziente und vielseitige Nutzung der Abwärme von Computersystemen möglich ist.

Diese Aufgabe wird durch die Merkmale der unabhängigen Patentansprüche gelöst. Weiterbildungen und vorteilhafte Ausgestaltungen sind in den jeweiligen abhängigen Patentansprüchen angegeben.

Gemäß einem ersten Aspekt der Erfindung wird die Aufgabe durch eine Kühlvorrichtung für ein Computersystem gelöst, das einen Verdampfer für ein Arbeitsmittel aufweist. Dabei ist wobei der Verdampfer thermisch an die mindestens eine Wärme erzeugende Komponente des Computersystems koppelbar und die Kühlvorrichtung ist eine Wärmekraftmaschine.

Bei der Kühlvorrichtung wird durch die Verdampfung des Arbeitsmittels eine effektive Wärmeaufnahme erreicht, was gute Kühleigenschaften bedingt. Die aufgenommene Wärme kann in der Kühlvorrichtung in einem thermodynamischen Kreisprozess der Wärmekraftmaschine in mechanische Energie umgewandelt werden, die vielfältig nutzbar ist. Es kann beispielsweise eine Dampfturbine mit Generator zur Umwandlung der mechanischen Energie in elektrische Energie eingesetzt werden und die elektrische Energie eingesetzt werden, um einen Teil des Primärenergiebedarfs des Computersystems zu decken. Auch ist es möglich, die Dampfturbine mit Kühlmittelkompressoren zu koppeln, die in einer Klimaanlage verwendet werden. Klimaanlagen werden häufig zur Klimatisierung von Räumen für Computersysteme eingesetzt. Wenn durch die Nutzbarmachung der Abwärme des Computersystems ein Teil der zum Betreiben der Klimaanlage benötigten Energie aufgebracht wird, führt dieses ebenfalls zur Verringerung des mit dem Betrieb des Computersystems verbundenen Energieverbrauchs.

In einer bevorzugten Weiterbildung der Kühlvorrichtung ist das Arbeitsmittel ein Gemisch aus Ammoniak und Wasser. Ein auf diesem Arbeitsmittel basierender thermodynamischer Kreisprozess wird auch als Kalina-Prozess bezeichnet. Dieses Gemisch verdampft bei Temperaturen unterhalb der maximal möglichen Arbeitstemperatur von elektronischen Komponenten, insbesondere von Prozessoren. Von daher ist ein Verdampfen eines solchen Arbeitsmittels gut zur Kühlung von Komponenten eines Computersystems geeignet. Zudem entsteht beim Verdampfen eine ammoniakreiche Dampfphase und eine ammoniakarme Flüssigphase, wodurch sich während des Verdampfens die Verdampfungstemperatur des noch flüssigen Teils des Gemisches erhöht. Die Erhöhung bedingt gute Wärmeübertragungseigenschaften im Verdampfer. Wird nach dem Durchlaufenden der Dampfturbine die Dampfphase wieder mit der nicht verdampften Flüssigphase des Arbeitsmittels vereinigt, erniedrigt sich analog der Siedepunkt wiederum, was zu einer Erniedrigung der Temperatur im Kondensator führt. Der damit erreichte größere Temperaturunterschied zwischen Verdampfer und Kondensator führt zu einem besseren Carnot-Wirkungsgrad, als mit einem Arbeitsmittel mit konstantem Siedepunkt erreicht werden könnte.

Gemäß einem zweiten Aspekt der Erfindung wird die Aufgabe durch ein Verfahren zum Kühlen mindestens einer Wärme erzeugenden Komponente eines Computersystems gelöst, wobei der Verdampfer thermisch an die mindestens eine Wärme erzeugende Komponente des Computersystems koppelbar ist und die Kühlvorrichtung eine Absorptionskältemaschine ist.

Die im Verdampfer aufgenommene Wärme kann in der Kühlvorrichtung durch den thermodynamischen Kreisprozess der Absorptionskältemaschine für Kühlzwecke genutzt werden. Beispielsweise kann eine Klimaanlage zur Klimatisierung der Räume des Computersysteme betrieben oder unterstützt werden., was effektiv den mit dem Betrieb des Computersystems verbundenen Primärenergiebedarf senkt.

Gemäß einem dritten Aspekt der Erfindung wird die Aufgabe durch ein Verfahren gelöst, bei dem ein Arbeitsmittel in einem Verdampfer durch die erzeugte Wärme zumindest teilweise verdampft wird und eine beim Verdampfen entstehende dampfförmige Phase des Arbeitsmittels in einer Dampfturbine unter Abgabe mechanischer Leistung entspannt wird.

Gemäß einem vierten Aspekt der Erfindung wird die Aufgabe durch ein Verfahren gelöst, bei dem ein Arbeitsmittel in einem Verdampfer durch die erzeugte Wärme teilweise verdampft wird, eine beim teilweisen Verdampfen entstehende dampfförmige Phase des Arbeitsmittels abgekühlt und kondensiert wird und das kondensierte Arbeitsmittel in einem weiteren Verdampfer unter der Aufnahme von Verdampfungswärme verdampft wird.

Die Vorteile des dritten und vierten Aspekts der Erfindung entsprechen denen des ersten und zweiten Aspekts.

Nachfolgend wird die Erfindung anhand von Ausführungsbeispielen mit Hilfe von drei Figuren näher erläutert.

### Es zeigen:

- Figur 1: eine schematische Darstellung eines ersten Ausführungsbeispiels einer Kühlvorrichtung für ein Computersystem,
- Figur 2: die schematische Darstellung eines zweiten Ausführungsbeispiels einer Kühlvorrichtung für ein Computersystem, und

- Figur 3: die schematische Darstellung eines dritten Ausführungsbeispiels einer Kühlvorrichtung für ein Computersystem.

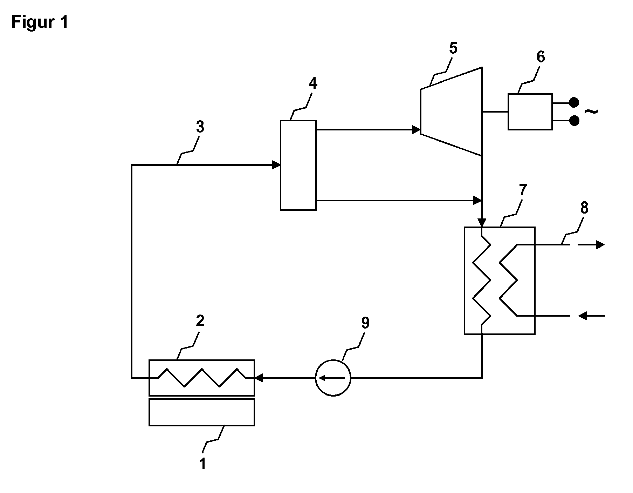

Bei der in der Figur 1 dargestellten Kühlvorrichtung befindet sich ein Prozessor 1 in direktem thermischen Kontakt mit einem Verdampfer 2. Der Verdampfer 2 ist über einen Arbeitsmittelkreislauf 3 mit einem Separator 4 verbunden. Ein erster Auslass des Separators 4 ist mit einer Dampfturbine 5 verbunden, die an einen Generator 6 gekoppelt ist. Ein Niederdruckauslass der Dampfturbine 5 und ein zweiter Auslass des Separators 4 sind zu einem Kondensator 7 geführt, der an einen Kühlwasserstrom 8 angebunden ist. Der Auslass des Kondensators 7 ist über eine Kondensatpumpe 9 mit dem Verdampfer 2 verbunden.

Beim Betrieb der in Figur 1 gezeigten Kühlvorrichtung wird Abwärme von einer Wärme erzeugenden Komponente des Computersystems, hier beispielhaft dem Prozessor 1, von dem Verdampfer 2 aufgenommen. Dazu steht der Verdampfer 2 in direktem thermischen Kontakt mit dem Prozessor 1. Der Verdampfer 2 weist dazu vorteilhafterweise eine Kontaktfläche zum Prozessor 1 und Befestigungselemente auf, die der Spezifikation von Kühlkörpern oder Kühlelementen für den Prozessor 1 entspricht.

Getrieben durch die Kondensatpumpe 9 wird der Verdampfer 2 von dem Arbeitsmittel 3 durchflossen. Dieses Arbeitsmittel ist eine bei den herrschenden Druckverhältnissen innerhalb des Arbeitsmittelskreislaufs 3 bei relativ niedrigen Temperaturen verdampfende oder teilweise verdampfende Flüssigkeit. Das Arbeitsmittel wird im Verdampfer 2 verdampft und nimmt dabei eine von seiner Verdampfungswärme und dem Durchfluss abhängige Wärmemenge auf. Die niedrigste Temperatur, auf die der Verdampfer damit gebracht werden kann, ist die Siedetemperatur des Arbeitsmittels bei dem im Arbeitsmittelkreislauf 3 im Verdampfer 2 herrschenden Druck. Aufgrund von Temperaturgradienten zwischen dem Prozessor 1 und dem Verdampfer 2, hervorgerufen durch die Wärmeleitwerte der eingesetzten Materialien sowie Wärmeübergangswiderstände insbesondere am Übergang vom Prozessor 1 zum Verdampfer 2 wird die Temperatur des Prozessors 1 etwas, beispielsweise einige Grad, höher liegen als die Siedetemperatur des Arbeitsmittels. Da Prozessoren und allgemein elektronische Bauelemente eine gewisse Höchsttemperatur nicht überschreiten dürfen, ab der es zu Fehlfunktionen und/oder einer Verkürzung der Lebensdauer kommt, ist das Arbeitsmittel entsprechend so zu wählen, dass sich im Betrieb am Bauelement eine vertretbare Arbeitstemperatur einstellt.

Besonders geeignet ist ein Gemisch aus Ammoniak und Wasser als Arbeitsmittel. Ein thermodynamischer Kreisprozess, der mit einem solchen Arbeitsmittel betrieben wird, wird auch als Kalina-Prozess bezeichnet. Eine Besonderheit bei dem Kalina-Prozess ist, dass beim Verdampfen eine ammoniakreiche Dampfphase und eine ammoniakarme Flüssigphase entstehen. Durch die Änderung der Ammoniakkonzentration in der flüssigen Phase erhöht sich deren Verdampfungstemperatur, was zu guten Wärmeübertragungseigenschaften im Verdampfer 2 führt.

Im Separator 4 werden die Flüssigphase und die Dampfphase voneinander getrennt. Die Dampfphase wird der als Niederdruckturbine ausgeführten Dampfturbine 5 zugeführt. Sie entspannt sich in der Dampfturbine 5 unter Abgabe mechanischer Energie, die auf den Generator 6 zur Erzeugung von elektrischem Strom übertragen wird. Der von dem Generator 6 erzeugte Strom kann dem Computersystem wieder zugeführt werden, wodurch sich der Primärenergiebedarf (Energieverbrauch) des Computersystems verringert. Alternativ kann die von der Dampfturbine 5 bereitgestellte mechanische Energie anderweitig genutzt werden, zum Beispiel zum Betreiben von Kompressoren für Klimaanlagen, die häufig im Zusammenhang mit großen Computersystemen zur zusätzlichen Kühlung über die Umluft eingesetzt werden. Indirekt wird auch damit der Energiebedarf eines Computersystems gesenkt.

Der am Niederdruckausgang der Dampfturbine 5 austretende entspannte ammoniakreiche Dampf wird mit der vom Separator 4 abgetrennten ammoniakarmen flüssigen Phase gemischt und dem Kondensator 7 zugeführt. Durch die Mischung erniedrigt sich der Siedepunkt des Arbeitsmittels, was zu einer Druckerniedrigung führt. Der von der Dampfturbine 5 ausgenutzte Druckunterschied erhöht sich folglich, was für eine effektive Energieumsetzung in der Dampfturbine 5 vorteilhaft ist. Zudem wird durch die Erniedrigung der Temperatur im Kondensator der erreichbare Temperaturunterschied zwischen Verdampfer und Kondensator größer, als es mit einem Arbeitsmittel mit konstantem Siedepunkt erreicht werden könnte. Dieses führt zu einem entsprechend besseren Carnot-Wirkungsgrad.

Im Kondensator 7 wird das Arbeitsmittel soweit abgekühlt, dass es verflüssigt und von der Kondensatpumpe 9 wiederum dem Verdampfer 2 zugeführt werden kann, so dass der thermodynamische Kreisprozess geschlossen wird. Alternativ kann ein Verflüssigen auch erst oder während der Kompression durch die Kondensatpumpe 9 erfolgen.

Um die Kondensationswärme des Arbeitsmittels abzuführen, wird der Kondensator 7 von einem Kühlwasserstrom 8 durchflossen. Dieser Kühlwasserstrom 8 kann Teil eines geschlossenen Kreislaufs sein, bei dem die aufgenommene Wärme beispielsweise außerhalb des Gebäudes durch Wärmetauscher an die Umgebungsluft abgegeben wird oder in eine Heizungsanlage eingespeist wird. Alternativ kann der Kühlwasserstrom 8 ein Frischwasserstrom sein, bei dem die aufgenommene Wärme dann beispielsweise der Warmwasserbereitung dient.

Der Übersichtlichkeit halber ist in Figur 1 lediglich ein Prozessor 1 als Wärme erzeugende Komponente des Computersystems gezeigt. In der Praxis wird eine sinnvolle Nutzung der Abwärme eines Computersystems in der gezeigten Art insbesondere dann effektiv sein, wenn die Kühlvorrichtung für ein großes Computersystem mit einer Vielzahl von Wärme erzeugenden Komponenten, also zum Beispiel einer Vielzahl von Prozessoren oder auch Netzteilen eingesetzt wird. In dem Fall kann vorgesehen sein, auf jeder Wärme erzeugenden Komponente einen Verdampfer 2 vorzusehen, wobei die Verdampfer 2 dann innerhalb des Arbeitsmittelkreislaufs 3 parallel angeordnet sind. Zur Regelung der Teilströme des Arbeitsmittels, die durch die einzelnen Verdampfer 2 geführt werden, kann an jedem Verdampfer 2 ein temperaturabhängig gesteuertes Ventil vorgesehen sein. Weiterhin ist es möglich, für jeweils mehrere Wärme erzeugende Komponenten, beispielsweise mehrere Prozessoren, die räumlich nah beieinander angeordnet sind, einen Verdampfer 2 vorzusehen, der über wärmeleitende Elemente, beispielsweise Heatpipes, mit den einzelnen Wärme erzeugenden Komponenten verbunden ist. Größere Serverfarmen weisen üblicherweise eine Mehrzahl von Serverracks auf, die jeweils wiederum mit einer Anzahl von einzelnen Servern bestückt sind, von denen jeder mehrere Prozessoren 1 aufweisen kann. Es kann dann beispielsweise ein Verdampfer 2 pro Server vorgesehen sein, der über Heatpipes mit den einzelnen Prozessoren 1 des Servers thermisch gekoppelt ist.

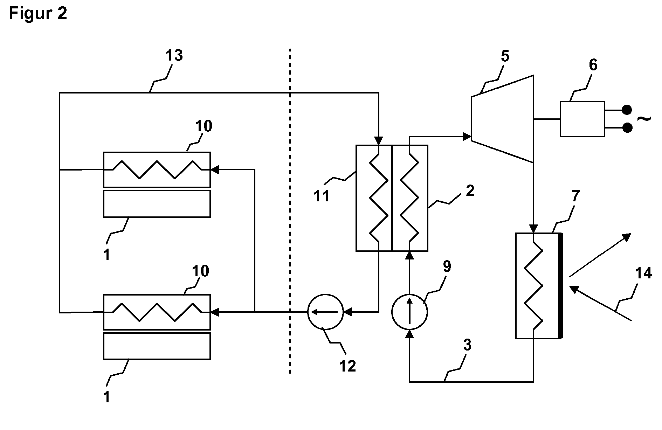

Figur 2 zeigt ein weiteres Ausführungsbeispiel einer Kühlvorrichtung für ein Computersystem. Gleiche Bezugszeichen in den Figuren 1 und 2 bezeichnen dabei gleiche oder gleichwirkende Elemente.

Bei der Kühlvorrichtung der Figur 2 stehen zwei Prozessoren 1 jeweils in direktem thermischen Kontakt mit einem ersten Wärmetauscher 10. Die ersten Wärmetauscher 10 bilden zusammen mit einem zweiten Wärmetauscher 11 und einer Kühlmittelpumpe 12 einen geschlossenen Kühlkreislauf 13. Mit dem zweiten Wärmetauscher 11 steht ein Verdampfer 2 in direktem thermischen Kontakt. Der Verdampfer 2 bildet mit einer Dampfturbine 5, die an einen Generator 6 gekoppelt ist, einem Kondensator 7 und einer Kondensatpumpe 9 einen geschlossenen Arbeitsmittelkreislauf 3. Der Kondensator 7 weist eine Kühlfläche 14 auf, die einem Kühlluftstrom 15 ausgesetzt ist.

Wie das in Figur 1 gezeigten Ausführungsbeispiel wird auch im Ausführungsbeispiel der Figur 2 die Verdampfungswärme eines Arbeitsmittels in einem Verdampfer 2 beim Ausführen eines thermodynamischen Kreisprozesses zur Kühlung von Prozessoren 1 eines Computersystems eingesetzt.

Im Unterschied zum Ausführungsbeispiel der Figur 1 weist der Arbeitsmittelkreislauf 3 keinen Separator 4 auf. Es ist somit für den thermodynamischen Kreisprozess nicht ein Binärverfahren mit einem gemischten Arbeitsmittel vorgesehen, das bei dem Verdampfen eine Konzentrationsänderung erfährt. Stattdessen ist ein Arbeitsmittel mit einem inhärent niedrigen Siedepunkt geeignet, wie beispielsweise Silikonöl oder andere organische Verbindungen. Ein mit einem solchen Arbeitsmittel durchgeführter thermodynamischer Kreisprozess wird auch als Organic Rankine-Cycle (ORC) bezeichnet.

Der Kondensator 7 ist in beiden Ausführungsbeispielen ebenfalls unterschiedlich ausgeführt. Beim Ausführungsbeispiel der Figur 2 ist statt der Flüssigkeitskühlung eine Luftkühlung des Kondensators 7 über die Kühlfläche 14 und einen Kühlluftstrom 15 vorgesehen.

Die Wärmeaufnahme von den Wärme erzeugenden Komponenten des Computersystems erfolgt im Ausführungsbeispiel der Figur 2 indirekt über die ersten Wärmetauscher 10 und die zweiten Wärmetauscher 11, die zusammen mit der Kühlmittelpumpe 12 den Kühlkreislauf 13 bilden. Die Wärmetauscher 10 sind dabei parallel im Kühlkreislauf 13 angeordnet. Damit ein ausreichender Kühlmitteldurchfluss durch die einzelnen Wärmetauschern 10 gewährleistet ist, kann vor jedem Wärmetauscher ein Regelventil vorgesehen sein. Dieses Regelventil kann beispielsweise den Durchfluss auf einen vorgegeben Wert regeln. Es kann auch vorgesehen sein, den Durchfluss abhängig von der Temperatur des Wärmetauschers 10 oder des entsprechenden Prozessors 1 zu regeln.

Durch einen solchen Aufbau kann auf einfache Weise erreicht werden, dass mehrere der Wärme erzeugenden Komponenten mit einem Verdampfer 2 thermisch gekoppelt werden können. Ein weiterer Vorteil dieser Anordnung ist, dass als erste Wärmetauscher 10 handelsübliche Kühlelemente für Flüssigkeitskühlungen eingesetzt werden können, die im Serverbereich standardmäßig eingesetzt werden. Auch wird erreicht, dass ein gegebenenfalls aggressives Arbeitsmittel im Arbeitsmittelkreislauf 3 räumlich von dem Computersystem getrennt werden kann, wie in der Figur 2 durch die gestrichelte Linie angedeutet ist. Beispielsweise kann pro Serverrack einer Serverfarm ein außerhalb der Server angebrachter Verdampfer 2 vorgesehen sein, der über einen oder mehrere zweiten Wärmetauscher 11 und einen oder mehrere Kühlkreisläufe 13 und eine entsprechende Anzahl an ersten Wärmetauschern 10 mit den Prozessoren 1 der Server verbunden ist.

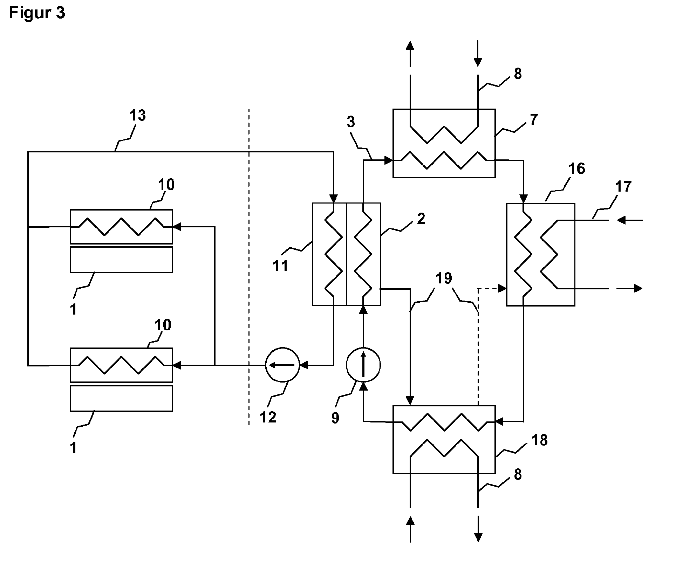

In Figur 3 ist ein weiteres Ausführungsbeispiel einer Kühlvorrichtung für ein Computersystem dargestellt. Gleiche Bezugszeichen wie in den Figuren 1 und 2 bezeichnen wiederum gleiche oder gleichwirkende Elemente.

Wie bei dem Ausführungsbeispiel der Figur 2 stehen auch hier zwei Prozessoren 1 jeweils in direktem thermischen Kontakt mit einem ersten Wärmetauscher 10. Die ersten Wärmetauscher 10 bilden zusammen mit einem zweiten Wärmetauscher 11 und einer Kühlmittelpumpe 12 einen geschlossenen Kühlkreislauf 13. Mit dem zweiten Wärmetauscher 11 ist ein Verdampfer 2 direkt thermisch gekoppelt. Der Verdampfer 2 bildet mit einem Kondensator 7, einem weiteren Verdampfer 16, einem Absorber 18 und einer Kondensatpumpe 9 einen geschlossenen Arbeitsmittelkreislauf 3. Der Kondensator 7 und der Absorber 18 sind thermisch an einen Kühlwasserstrom 8 gekoppelt. Der weitere Verdampfer 16 steht in thermischen Kontakt mit einem Kältekreislauf 17. Vom Verdampfer 2 zum Absorber 18 und vom Absorber 18 zum weiteren Verdampfer 16 sind Rückführungen 19 vorgesehen.

Wie in den zuvor dargestellten Ausführungsbeispielen wird auch im Ausführungsbeispiel der Figur 3 die Verdampfungswärme eines Arbeitsmittels in einem Verdampfer 2 genutzt, um mit der Abwärme der Prozessoren 1 eines Computersystems einen thermodynamischen Kreisprozesses anzutreiben. Der thermodynamische Kreisprozess dient hier jedoch nicht der Erzeugung mechanischer Energie, sondern der Kälteerzeugung mittels einer Absorptionskältemaschine. Dazu wird ein Arbeitmittel mit mindestens zwei ineinander gelösten Komponenten eingesetzt, zum Beispiel eine Mischung aus Ammoniak und Wasser oder in Wasser gelöstes Lithiumbromid. Bei Absorptionskältemaschinen wird der Verdampfer 2 häufig auch als Austreiber bezeichnet.

Im Verdampfer 2 wird das Arbeitsmittel teilweise verdampft, wobei eine der Komponenten des Arbeitsmittels in der dampfförmigen Phase angereichert wird. Diese Komponente (Ammoniak bei der Ammoniak/Wasser-Mischung, Wasser bei der Lithiumbromid/Wasser-Mischung) wird auch Kältemittel genannt. In der verbleibenden flüssigen Phase wird entsprechend die andere Komponente des Arbeitsmittels angereichert vorliegen. Diese flüssige Phase wird über die in der Figur 3 mit einer durchgezogenen Linie dargestellten Rückführleitung 19 zum Absorber 18 zurückgeführt. Die kältemittelreiche Dampfphase wird anschließend im Kondensator 7 abgekühlt und verflüssigt. Die dabei anfallende Wärme wird vom Kühlwasserstrom 8 aufgenommen und kann zu Heizzwecken und/oder zur Warmwasserbereitung genutzt werden.

Das kältemittelreiche Arbeitsmittel wird dann im weiteren Verdampfer 16 bei niedrigem Druck verdampft, wobei zur Druckerniedrigung ein Drosselelement vorgesehen sein kann. Aufgrund des niedrigen Druckes wird Verdampfungswärme auf einem so niedrigen Temperaturniveau aus dem Kältekreislauf 17 aufgenommen, dass der Kältekreislauf 17 zu Raumklimatisierung eingesetzt werden kann. Auf diese Weise kann die Abwärme des Computersystems direkt, das heißt ohne den Umweg über mechanische Energie, zur Klimatisierung der Räume, in denen das Computersystem betrieben wird, genutzt werden. Der Gesamtbedarf an Primärenergie zum Betreiben des Computersystems kann so gesenkt werden.

Nach dem Verdampfen wird das kältemittelreiche Arbeitsmittel im Absorber 18 wiederum kondensiert und in dem vom Verdampfer 2 zurückgeleiteten kältemittelarmen Arbeitsmittel gelöst. Die dabei abgegebene Kondensation- und Lösungswärme wird vom Kühlmittelstrom 8 abgeführt. Dabei kann zusätzlich ein Hilfmittelkreislauf mit einem Hilfsmittel, zum Beispiel Wasserstoffgas im Fall der der Ammoniak/Wasser-Mischung als Arbeitsmittel, vorgesehen sein. Die in der Figur 3 mit einer gestrichelten Linie dargestellte optionale Rückführung 19 dient dann der Rückführung des Hilfsmittels vom Absorber 18 zum weiteren Verdampfer 16.

Das Arbeitsmittel wird vom Absorber 18 mit Hilfe der Arbeitsmittelpumpe 9 anschließend wieder dem Verdampfer 2 zugeführt, womit der Kreisprozess geschlossen ist.

Bei allen drei Ausführungsbeispielen kann durch die Wahl eines geeigneten Arbeitsmittels und durch geeignete Dimensionierung der Komponenten erreicht werden, dass eine Nutzung der Abwärme bereits bei einer relativ niedrigen Temperatur des Verdampfers 2 im Bereich von 60 bis 100 °C effizient möglich ist. Bei solchen Temperaturen können Bauelemente eines Computersystems, insbesondere Prozessoren, durchaus ohne die Gefahr von Fehlfunktionen und Beschädigung betrieben werden.

Selbstverständlich können Merkmale der Ausführungsbeispiele auch auf andere Art miteinander kombiniert werden. Beispielsweise kann die indirekte Wärmeübertragung von den Prozessoren 1 auf den Verdampfer 2 über den Kühlkreislauf 13 auch im Zusammenhang mit dem in Figur 1 gezeigten Kalina-Kreisprozess eingesetzt werden oder es kann die im Zusammenhang mit der Figur 2 angegebene Luftkühlung des Kondensators 7 auch bei den anderen Ausführungsbeispielen zur Anwendung kommen.

Bezugszeichenliste
- 1: Prozessor
- 2: Verdampfer
- 3: Arbeitsmittelkreislauf
- 4: Separator
- 5: Dampfturbine
- 6: Generator
- 7: Kondensator
- 8: Kühlwasserstrom
- 9: Kondensatpumpe
- 10: Erster Wärmetauscher
- 11: Zweiter Wärmetauscher
- 12: Kühlmittelpumpe
- 13: Kühlkreislauf
- 14: Kühlfläche
- 15: Kühlluftstrom
- 16: Weiterer Verdampfer
- 17: Kältekreislauf
- 18: Absorber
- 19: Rückführung

## Patentansprüche

1. Kühlvorrichtung für ein Computersystem, aufweisend einen Verdampfer (2) für ein Arbeitsmittel, wobei der Verdampfer (2) thermisch an die mindestens eine Wärme erzeugende Komponente des Computersystems koppelbar ist und die Kühlvorrichtung eine Wärmekraftmaschine ist.

2. Kühlvorrichtung nach Anspruch 1, bei der die Wärmekraftmaschine eine Dampfturbine (5) aufweist.

3. Kühlvorrichtung nach einem der Ansprüche 1 oder 2, bei der das Arbeitsmittel organische Komponenten enthält und eine niedrige Siedetemperatur aufweist.

4. Kühlvorrichtung nach einem der Ansprüche 1 oder 2, bei der das Arbeitsmittel ein Gemisch aus Ammoniak und Wasser aufweist.

5. Kühlvorrichtung nach Anspruch 4, bei der ein Separator (4) zur Trennung einer dampfförmigen und einer flüssigen Phase des Arbeitsmittels dem Verdampfer (2) nachgeschaltet ist, wobei die Kühlvorrichtung so eingerichtet ist, dass die dampfförmige Phase einer Dampfturbine (5) zugeführt wird und nach einem Entspannen in der Dampfturbine (5) wieder mit der flüssigen Phase zusammengeführt wird.

6. Kühlvorrichtung für ein Computersystem, aufweisend einen Verdampfer (2) für ein Arbeitsmittel, wobei der Verdampfer (2) thermisch an die mindestens eine Wärme erzeugende Komponente des Computersystems koppelbar ist und die Kühlvorrichtung eine Absorptionskältemaschine ist.

7. Kühlvorrichtung nach Anspruch 6, bei der ein weiterer Verdampfer (16) vorgesehen ist, der thermisch mit einem Kältekreislauf (17) einer Klimaanlage gekoppelt ist.

8. Kühlvorrichtung nach einem der Ansprüche 6 oder 7, bei der das Arbeitsmittel ein Gemisch aus Ammoniak und Wasser aufweist.

9. Kühlvorrichtung nach einem der Ansprüche 6 oder 7, bei der das Arbeitsmittel Lithiumbromid enthält.

10. Kühlvorrichtung nach einem der Ansprüche 1 bis 9, bei der der Verdampfer (2) zum Übertragen von Wärme über eine Kontaktfläche direkt mit der mindestens einen Wärme erzeugenden Komponente verbindbar ist.

11. Kühlvorrichtung nach einem der Ansprüche 1 bis 9, bei der der Verdampfer (2) zum Übertragen von Wärme über ein wärmeleitendes Element mit der mindestens einen Wärme erzeugenden Komponente verbindbar ist.

12. Kühlvorrichtung nach einem der Ansprüche 1 bis 9, bei der der Verdampfer (2) zum Übertragen von Wärme über eine Wärme transportierende Anordnung in mit der mindestens einen Wärme erzeugenden Komponente verbindbar ist.

13. Kühlvorrichtung nach Anspruch 12, bei der die Wärme transportierende Anordnung mindestens einen ersten Wärmetauscher (10) und einen damit gekoppelten zweiten Wärmetauscher (11) umfasst, wobei der mindestens eine erste Wärmetauscher (10) direkt mit der mindestens einen Wärme erzeugenden Komponente verbindbar ist und der zweite Wärmetauscher (11) thermisch mit dem Verdampfer (2) verbunden ist.

14. Verfahren zum Kühlen mindestens einer Wärme erzeugenden Komponente eines Computersystems, bei dem
- ein Arbeitsmittel in einem Verdampfer (2) durch die erzeugte Wärme zumindest teilweise verdampft wird und
- eine beim Verdampfen entstehende dampfförmige Phase des Arbeitsmittels in einer Dampfturbine (5) unter Abgabe mechanischer Leistung entspannt wird.

15. Verfahren zum Kühlen mindestens einer Wärme erzeugenden Komponente eines Computersystems, bei dem
- ein Arbeitsmittel in einem Verdampfer (2) durch die erzeugte Wärme teilweise verdampft wird,
- eine beim teilweisen Verdampfen entstehende dampfförmige Phase des Arbeitsmittels abgekühlt und kondensiert wird und
- das kondensierte Arbeitsmittel in einem weiteren Verdampfer (16) unter der Aufnahme von Verdampfungswärme verdampft wird.
